# EUROPÄISCHE PATENTSCHRIFT

(11) **EP 3 759 743 B1**
(45) Veröffentlichungstag und Bekanntmachung des Hinweises auf die Patenterteilung: **21.10.2026**
(21) Anmeldenummer: 19712507.3
(22) Anmeldetag: 26.02.2019
(51) Int. Cl.: H10F 10/142, H10F 77/14

(54) **MEHRFACHSOLARZELLE**
MULTI-JUNCTION SOLAR CELL
CELLULE MULTIJONCTION

(30) Priorität: 01.03.2018 DE 102018001592
(43) Veröffentlichungstag der Anmeldung: 06.01.2021
(73) Patentinhaber: AZUR SPACE Solar Power GmbH, 74072 Heilbronn (DE)
(72) Erfinder: FUHRMANN, Daniel, 74081 Heilbronn (DE); KELLER, Gregor, 74080 Heilbronn (DE); VAN LEEST, Rosalinda, NL 4921 LE Made (NL)
(74) Vertreter: Koch Müller Patentanwaltsgesellschaft mbH
(86) Internationale Anmeldenummer: PCT/EP2019/000057
(87) Internationale Veröffentlichungsnummer: WO 2019/166126

(56) Entgegenhaltungen:
- EP-A1- 2 779 253
- EP-A2- 1 047 136
- US-A- 4 688 068
- US-A1- 2009 188 554
- US-A1- 2012 240 987
- US-A1- 2013 263 923

## Beschreibung

Die Erfindung betrifft eine Mehrfachsolarzelle.

Zur besseren Ausnutzung des Sonnenspektrums umfassen Mehrfachsolarzellen im Allgemeinen drei oder mehr Teilzellen mit unterschiedlichen, aufeinander abgestimmten Bandlücken, wobei die oberste Teilzelle die größte Bandlücke und die unterste Teilzelle die kleinste Bandlücke aufweist und sich die oberste Teilzelle auf der Sonnen-zugewandten Seite der Mehrfachsolarzelle befindet.

Derartige Mehrfachsolarzellen sind beispielsweise aus dem Vortrag "Development of Upright Metamorphic 4J Space Solar Cells", von W. Guter et al., Space Power Workshop 2017, Manhattan Beach, CA bekannt.

Die oberste Teilzelle einer Mehrfachsolarzelle, im Folgenden auch als Oberzelle bezeichnet, besteht bei gitterangepassten Mehrfachsolarzellen auf Germanium-Substrat häufig aus InGaP mit einem Bandabstand von ca. 1,88 eV.

Die InGaP Oberzelle zeigt eine offene Klemmenspannung V_{oc} von etwa 1,4 V auf. Zur Erhöhung der Effizienz von Mehrfachsolarzellen werden sowohl metamorphe als auch gitterangepasste Konzepte mit mehr als 3 Teilzellen verfolgt.

Die Oberzelle wird dabei aus InAlGaP gebildet, wobei durch die Zugabe von Al sich der Bandabstand vergrößert und die offene Klemmspannung der Oberzelle sich bis auf Werte größer als 1.4 V erhöht.

Zwar zeigt die InAlGaP Oberzelle im Vergleich zu der Al-freien InGaP Oberzelle eine höhere Bandlücke und eine höhere offene Klemmspannung V_{oc}, jedoch weist die InAlGaP Oberzelle gegenüber der InGaP Oberzelle einen ca. fünffach höheren Schichtwiderstand auf.

Der höhere Schichtwiderstand der InAlGaP-Oberzelle führt in der Mehrfachsolarzelle insbesondere bei höheren Strömen zu größeren Serienwiderstandsverlusten. Um die Verluste bei höheren Strömen, insbesondere für Konzentratoranwendungen, d.h. CPV Anwendungen gering zu halten, muss der Abstand zwischen den Metallfingern auf der Oberseite der InAlGaP Oberzelle gegenüber der InGaP Oberzelle verkleinert werden. Dies führt allerdings zu einer höheren Abschattung, wodurch der Wirkungsgrad der gesamten Solarzelle sinkt.

Bei einer Anwendung für CPV ist daher für eine hohe Effizienz eine ausreichende Querleitfähigkeit besonders wichtig.

Aus "Evolution of a 2.05 eV AlGaInP Top Sub-Cell for 5 and 6J-IMM Applications", Arthur B. Cornfeld et al., 38th IEEE Photovoltaic Specialists Conference (PVSC), 2012, ist bekannt, eine Oberzelle als Heterozelle mit einem InGaP-Emitter und einer InAlGaP Basis auszubilden. Hierbei tritt jedoch trotzdem ein erheblicher Spannungsverlust von ca. 160 mV im Vergleich zu einer reinen InAlGaP-Zelle auf.

Aus der US 4 688 068 A1, der EP 2 779 253 A1 und der US 2012 / 240 987 A1 sind Mehrfachzellen bekannt, wobei bei den Teilzellen zwischen dem Emitter und Basis eine MQW-Struktur ausgebildet ist.

Weitere Solarzellenstruktur sind aus der US 2013 / 263 923 A1, der EP 1 047 136 A2 und der US 2009 / 188 554 A1 bekannt.

Vor diesem Hintergrund besteht die Aufgabe der Erfindung darin, eine Vorrichtung anzugeben, die den Stand der Technik weiterbildet.

Die Aufgabe wird durch eine Mehrfachsolarzelle mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine stapelförmige Mehrfach-Solarzelle umfassend einen Stapel aus mindestens drei oder vier oder mehr

Teilzellen bereitgestellt, wobei jede Teilzelle einen Emitter und eine Basis aufweist und das Licht durch die oberste Teilzelle auf die weiteren Teilzellen dringt.

Zumindest umfasst oder besteht die oberste Teilzelle aus einem III-V-Halbleitermaterial, wobei der Emitter der obersten Teilzelle ein Übergitter umfasst oder aus einer Übergitterstruktur besteht.

Es sei angemerkt, dass zwischen zwei unmittelbar aufeinanderfolgenden Teilzellen eine Tunneldiode ausgebildet ist. Auch sei angemerkt, dass die jeweiligen Teilzellen als N/P Teilzellen ausgebildet sind, das heißt der n-Emitter ist jeweils oberhalb der p-Basisschicht angeordnet.

Anders ausgedrückt, das Licht durchdringt zuerst die Emitterschicht bevor es die Basisschicht durchdringt. Es versteht sich, dass die Tunneldiode aus einer hochdotierten dünnen n-Schicht und einer hochdotierten dünnen p-Schicht besteht und die beiden Schichten der Tunneldiode stoffschlüssig aufeinander angeordnet sind.

Es versteht sich, dass der n-Emitter und die p-Basisschicht der jeweiligen Teilzellen einen p-n-Übergang ausbilden.

Weiterhin sei angemerkt, dass n-Emitter und p-Basis der jeweiligen Teilzellen aus demselben Material, aber unterschiedlicher Dotierung, oder aus unterschiedlichem Material und unterschiedlicher Dotierung bestehen können.

Es versteht sich, dass ein Übergitter aus einer periodischen Folge mehrerer unterschiedlicher sehr dünner Halbleiterschichten gebildet wird. Die unterschiedlichen Halbleiterschichten weisen eine unterschiedliche Bandlückenenergie auf und bilden paarweise eine Folge von Potentialtöpfen und Potentialbarrieren aus. Mit sehr dünnen Halbleiterschichten werden vorliegend Halbleiterschichten mit einer Dicke unterhalb von 10 nm bezeichnet.

Vorzugsweise ist ein Potentialtopf von Potentialbarrieren umgeben, d.h. die Übergitterstruktur beginnt mit einer Potentialbarriere-Schicht und endet mit einer Potentialbarriere-Schicht.

Insbesondere die Potentialbarrieren, also die entsprechenden BarriereSchichten sind dabei so dünn ausgebildet, dass ein Überlappen der Wellenfunktionen zwischen benachbarten Potentialtöpfen möglich ist und sich ein sogenanntes Übergitter ausbildet.

Es versteht sich, dass die unterschiedlichen dünnen Schichten eines Übergitters jeweils unterschiedliche elektrische und optische Eigenschaften aufweisen, welche das Übergitter in sich vereint. Ferner versteht sich, dass die Bandlückenenergie des Materials der Topfschichten kleiner ist als die Bandlückenenergie des Materials der Barriereschichten.

Ein Vorteil ist, dass mittels der Ausbildung eines Übergitters in dem Emitter sich in überraschender Weise zeigte, das sich gegenüber einer AlInGaP Oberzelle eine hohe Querleitfähigkeit erzielen lässt, ohne dass die offene Klemmspannung der Mehrfachsolarzelle signifikant reduziert wird.

So lassen sich im Vergleich zu den bisherigen Lösungen mit der Ausbildung einer Übergitterstruktur in dem Emitter der Oberzelle eine Querleitfähigkeit in einem Bereich von unter 700 Ω/ □. bei nur geringen Einbußen bei der Quellenspannung im Bereich von wenigen mV erzielen.

Anders ausgedrückt lässt sich mittels Ausbildung eines Übergitters im Emitter der Oberzelle die hohe offene Klemmspannung erhalten und gleichzeitig der Schichtwiderstand der Oberzelle signifikant reduzieren.

Besonders überraschend hat sich gezeigt, dass trotz der Barriereschichten innerhalb der Übergitterstruktur im Emitter der Kurzschlussstrom der Solarzelle nicht negativ beeinflusst wird und der Kurzschlussstrom gegenüber einer herkömmlichen Solarzelle mit einem Emitter aus einer Bulkschicht nicht reduziert wird.

Es sei angemerkt, dass die Übergitterstrukturen aufgrund der aufwändigen Herstellung bisher ausschließlich zur Aufweitung des Absorptionsgebietes in intrinsischen Zonen, d.h. zwischen Emitter und Basis von Teilzellen, ausgebildet werden, um den Absorptionsbereich in das Langwellige zu erweitern oder die Strahlungshärte von Teilzellen zu verbessen.

Erfindungsgemäß besteht das Übergitter aus mehreren gestapelten Schichten, wobei sich benachbarte Schichten hinsichtlich einer Zusammensetzung in mindestens einem chemischen Element und/oder hinsichtlich der Stöchiometrie der in den Schichten enthaltenen Elemente unterscheiden. Somit bestehen die benachbarten Schichten aus Materialien mit unterschiedlicher Bandlückenenergie und bilden so ein Übergitter.

Anders ausgedrückt zwei unmittelbar aufeinanderfolgende Schichten weisen vorzugsweise einen Unterschied in der Elementzusammensetzung und/oder in der Stöchiometrie auf.

Gemäß einer weiteren Ausführungsform umfasst der Emitter der obersten Teilzelle neben dem Übergitter noch mindestens eine weitere Schicht, die Teil des Emitters ist.

Vorzugsweise ist die weitere Schicht unterhalb des Übergitters, d.h. zwischen der Basisschicht der Oberzelle und dem Übergitter ausgebildet.

In einer Weiterbildung ist die weitere Schicht oberhalb des Übergitters ausgebildet.

In einer anderen Ausführungsform ist eine weitere Schicht sowohl unterhalb als auch oberhalb des Übergitters ausgebildet.

Vorzugsweise weist das Übergitter wenigstens fünf jedoch höchstens 30 Perioden auf. Höchst vorzugsweise umfasst das Übergitter genau 18 Perioden. Es sei angemerkt, dass jede Periode genau aus einem Schichtpaar besteht.

In einer Weiterbildung umfasst das Übergitter mehrere Barriereschichten und mehrere Topfschichten, z.B. jeweils fünf Barriereschichten und fünf Topfschichten, wobei die Barriereschichten und die Topfschichten alternierend gestapelt sind und das Material der Topfschichten eine geringere Bandlückenenergie aufweist als das Material der Barriereschichten.

Bevorzugt weist jede Barriereschicht eine Schichtdicke von höchstens 6 nm, z.B. 1,5 nm, auf und jede Topfschicht eine Schichtdicke von höchstens 8 nm, z.B. 2 nm auf.

Gemäß einer weiteren Ausführungsform weist das Übergitter eine Gesamtdicke kleiner als 500 nm oder zwischen 20 nm und 100 nm auf.

In einer Weiterbildung umfasst das Übergitter zwischen 3 und 100 alternierende Schichtpaare aus Topfschichten und Barriereschichten.

Durch das Beschränken der Schichtdicken wird sichergestellt, dass sich ein Übergitter mit Quantentöpfen und dünnen Barrieren ausbildet. Die dabei auftretende Quantisierung innerhalb der Quantentöpfe erhöht die Energie, ab der Photonen absorbiert werden und sichert hierdurch eine hohe offene Klemmspannung der Solarzelle. Durch die dünnen Barrieren wird der vertikale Stromtransport begünstigt, sodass Ladungsträger, die durch Absorption in dem Emitter generiert werden, noch getrennt werden können und somit zum Kurzschlussstrom der Solarzelle beitragen können.

Die effektive Bandlücke der Übergitterstruktur kann durch Variation der Dicke der Topfschichten, der Dicke der Barriereschichten und der Dotierstoffkonzentrationen abgestimmt werden.

In einer anderen Weiterbildung weist jede Barriereschicht eine erste Dotierstoffkonzentration auf und jede Topfschicht eine zweite Dotierstoffkonzentration auf, wobei die erste Dotierstoffkonzentration gleich oder größer oder kleiner als die zweite Dotierstoffkonzentration ist. Vorzugsweise ist die erste Dotierstoffkonzentration um einen Faktor zwei größer oder kleiner als die zweite Dotierstoffkonzentration.

Erfindungsgemäß umfasst der Emitter der obersten Teilzelle Al und / oder die Basis der obersten Teilzelle besteht aus AlInGaP oder umfasst AlInGaP.

Erfindungsgemäß ist das Übergitter als n-InAlP / n-InGaP -Übergitter oder als n-InGaP / n-InAlP Übergitter ausgebildet. Es versteht sich, dass dabei die Topfschicht aus n-InGaP und die Barriereschicht aus n-InAlP gebildet wird. Erfindungsgemäß umfasst oder besteht die Basis der obersten Teilzelle aus p-AlInGaP.

Eine Übergitter-Schicht aus alternierenden InGaP- und InAlP-Schichten weist aufgrund der besseren Querleitung in den InGaP-Töpfen eine deutlich höhere Leitfähigkeit auf, als eine AlInGaP -Bulk-Schicht gleicher Dicke.

Im Vergleich zu einer reinen AlInGaP-Zelle treten zwar immer noch leichte Spannungsverluste auf. Die Spannungsverluste sind im Vergleich zu den Verlusten einer reinen InGaP-Zelle jedoch kleiner und der Wirkungsgrad der Solarzelle mit Übergitterstruktur im Emitter ist hierdurch erhöht, indem die Verbesserungen durch den reduzierten Schichtwiderstand deutlich überwiegen.

Erfindungsgemäß ist das Übergitter als n-InₓGa₁₋ₓP / n-In_{y}Ga_{1-y}P -Übergitter gebildet. Es versteht sich, dass dabei der In-Anteil in den Topfschichten (x) größer als der In-Anteil in den Barriereschichten (y) ist. Durch den unterschiedlichen In-Anteil in den alternierenden Schichten führt der hierdurch einhergehende Unterschied in der Bandlückenenergie der alternierenden Schichten ebenfalls zur Ausbildung eines Übergitters.

Gemäß einer weiteren Ausführungsvariante sind mindestens zwei Teilzellen oder alle Teilzellen der Mehrfach-Solarzelle aufeinander monolithisch ausgebildet. In einer alternativen Ausführungsform umfasst die Mehrfachsolarzelle einen metamorphen Puffer und / oder einen Halbleiterbond.

Vorzugsweise ist der metamorphe Puffer zwischen der untersten Teilzelle und der obersten Teilzelle ausgebildet ist. In einer Weiterbildung ist die unterste Teilzelle aus Ge gebildet.

In einer anderen Ausführungsform umfasst die Mehrfachsolarzelle mindestens vier Teilzellen oder genau vier Teilzellen oder genau fünf Teilzellen oder genau sechs Teilzellen, wobei die oberste Teilzelle eine Bandlücke zwischen 1,75 eV und 2,1 eV und die zweitoberste Teilzelle eine Bandlücke zwischen 1,55 eV und 1,75 eV aufweist. Bei der zweitobersten Teilzelle umfasst der Emitter und die Basis jeweils InGaP.

In einer anderen Weiterbildung umfasst die stapelförmige Mehrfach-Solarzelle mindestens eine Bragg-Spiegelschicht, auch als Bragg Reflektor oder dielektrischer Spiegel bezeichnet.

Gemäß einer anderen Ausführungsform weist die oberste Teilzelle auf der Oberseite einen oder mehrere Kontaktfinger auf.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt:
- Figur 1: eine Ansicht auf eine erste erfindungsgemäße Ausführungsform einer stapelförmigen Mehrfachsolarzelle,
- Figur 2: eine Ansicht auf eine zweite erfindungsgemäße Ausführungsform einer stapelförmigen Mehrfachsolarzelle,
- Figur 3: eine Ansicht auf eine dritte erfindungsgemäße Ausführungsform einer stapelförmigen Mehrfachsolarzelle.

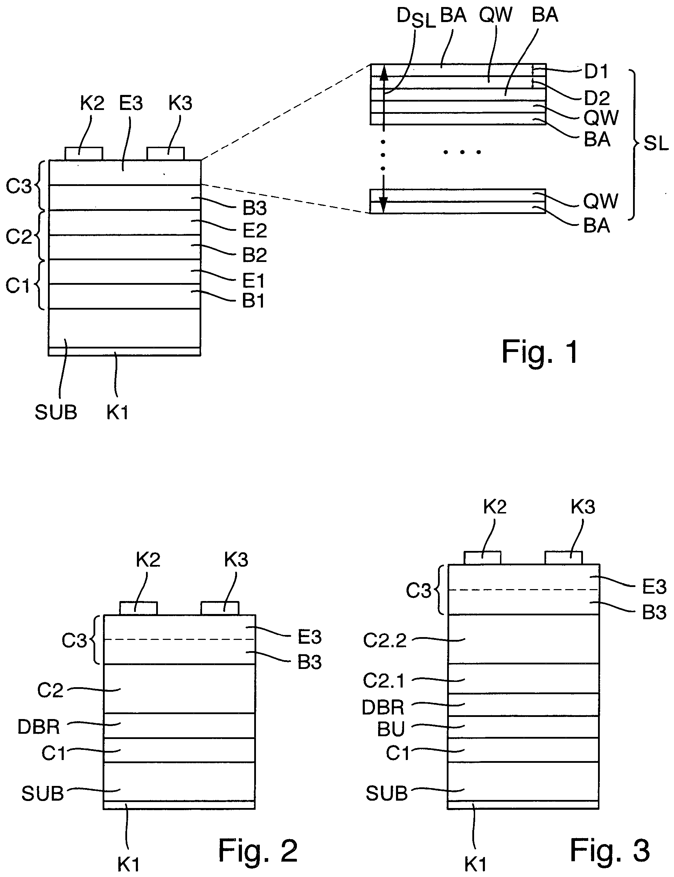

Die Abbildung der Figur 1 zeigt eine Ansicht einer ersten Ausführungsform einer stapelförmigen Mehrfach-Solarzelle MJ, umfassend einen Stapel ST aus einer Substratschicht SUB, einer untersten Teilzelle C1, einer mittlere Teilzelle C2 und einer obersten Teilzelle C3. Auf einer Unterseite des Stapels ST ist eine flächige Kontaktschicht K1 ausgebildet. Auf einer Oberseite des Stapels sind Kontaktfinger K2, K3 angeordnet.

Jede Teilzelle C1, C2 und C3 weist jeweils eine Basis B1, B2, B3 und einen Emitter E1, E2, E3 auf, wobei Emitter E3 und Basis B3 der obersten Teilzelle C3 jeweils aus einem III-V-Halbleitermaterial bestehen.

Der Emitter E3 der obersten Teilzelle C3 umfasst ein Übergitter SL. Das Übergitter umfasst mehrere dünne Topfschichten QW mit der Dicke D2 und mehrere dünne Barriereschichten BA mit der Dicke D1, wobei die Topfschichten QW und die Barriereschichten BA alternierend aufeinander gestapelt sind. Die Gesamtdicke des Übergitters D_{SL} ergibt sich aus der Dicke der alternierenden Schichten und der Anzahl der Perioden.

In der Abbildung der Figur 2 ist eine weitere Ausführungsform einer erfindungsgemäßen Mehrfach-Solarzelle MJ dargestellt. Im Folgenden werden nur die Unterschiede zu der Abbildung der Figur 1 erläutert.

Die Dreifach-Solarzelle MJ umfasst einen zwischen der untersten Teilzelle C1 und der mittleren Teilzelle C2 angeordneten Bragg-Spiegelschicht DBR. Eine bevorzugte Materialkombination für die Teilzellen ist die folgende: Die unterste Teilzelle C1 ist als Ge-Zelle ausgebildet, die mittlere Teilzelle C2 als (Al)InGaAs-Zelle und die oberste Teilzelle C3 weist eine p-InAlGaP Basis B3 und ein n-InAlP/n-InGaP-Übergitter als Emitter E3 auf.

In einer nicht dargestellten Ausführungsform ist zwischen der Ge-Zelle und der unmittelbar nachfolgenden Teilzelle ein metamorpher Puffer ausgebildet. Hierbei ist der metamorpher Puffer anstelle des Bragg-Spiegelschicht DBR oder zwischen der Bragg-Spiegelschicht und der Ge-Zelle angeordnet.

In einer anderen Materialkombination ist die unterste Teilzelle C1 als Ge-Zelle ausgebildet, die mittlere Teilzelle C2 als InGaAs-Zelle ausgebildet. Die oberste Teilzelle C3 weist eine p-InGaP Basis B3 und ein n-InₓGa₁₋ₓP / n-In_{y}Ga_{1-y}P - Übergitter als Emitter E3 auf.

Hierbei ist der In-Anteil der Topfschichten x größer als der In-Anteil der Barriereschichten y, sodass die Bandlückenenergie des Materials der Topfschichten kleiner ist als die Bandlückenenergie des Materials der Barriereschichten.

In der Abbildung der Figur 3 ist eine weitere Ausführungsform einer erfindungsgemäßen Mehrfach-Solarzelle MJ dargestellt. Im Folgenden werden nur die Unterschiede zu der Abbildung der Figur 1 erläutert.

Die Mehrfach-Solarzelle MJ ist als Vierfach-Solarzelle ausgebildet, aufweisend das Substrat SUB, die unterste Teilzelle, z.B. aus Ge, eine PufferSchicht BU, eine Bragg-Spiegelschicht DBR, eine erste mittlere Teilzelle C2.1, z.B. aus InGaAs, eine zweite mittlere Teilzelle C2.2, z.B. aus AlInGaAs sowie die oberste Teilzelle C3. Die oberste Teilzelle umfasst einen Basisschicht B3, z.B. aus p-InAlGaP, und ein Übergitter, z.B. ein n-InAlP/n-InGaP-Übergitter, als Emitterschicht E3.

## Patentansprüche

1. Stapelförmige Mehrfach-Solarzelle (MJ) umfassend einen Stapel (ST) aus einer untersten Teilzelle (C1), mindestens einer mittleren Teilzelle (C2) und einer obersten Teilzelle (C3), wobei
- jede Teilzelle (C1, C2, C3) einen Emitter (E1, E2, E3) und eine Basis (B1, B2, B3) aufweist,
- zumindest die oberste Teilzelle (C3) aus einem III-V-Halbleitermaterial besteht oder ein III-V-Halbleitermaterial umfasst, wobei durch die oberste Teilzelle das Licht auf die weiteren Teilzellen dringt, wobei die Basis (B3) der obersten Teilzelle (C3) aus p-AllnGaP besteht oder p-AlInGaP zumindest umfasst,
**dadurch gekennzeichnet, dass**
- der Emitter (E3) der obersten Teilzelle (C3) ein Übergitter (SL) umfasst oder aus einem Übergitter (SL) besteht,
- das Übergitter (SL) nur in dem Emitter der obersten Teilzelle (C3) ausgebildet ist,
- das Übergitter (SL) als n-InAlP / n-InGaP -Übergitter mit n-InAlP als Barriereschicht und n-InGaP als Topfschicht gebildet wird, oder
- das Übergitter (SL) als n-InₓGa₁₋ₓP / n-In_{y}Ga_{1-y}P -Übergitter gebildet wird, wobei der In-Anteil in den Topfschichten (x) größer als der In-Anteil in den Barriereschichten (y) ist.

2. Stapelförmige Mehrfach-Solarzelle (MJ) nach Anspruch 1, **dadurch gekennzeichnet, dass** das Übergitter (SL) aus mehreren gestapelten Schichten besteht, wobei sich benachbarte Schichten hinsichtlich einer Zusammensetzung in mindestens einem chemischen Element und/oder hinsichtlich der Stöchiometrie unterscheiden.

3. Stapelförmige Mehrfach-Solarzelle (MJ) nach Anspruch 1 oder 2, **dadurch gekennzeichnet, dass** der Emitter (E3) der obersten Teilzelle zusätzlich zu dem Übergitter (SL) eine weitere Schicht umfasst, und die weitere Schicht Teil des Emitters (E3) ist.

4. Stapelförmige Mehrfach-Solarzelle (MJ) nach Anspruch 1 oder 2 oder 3, **dadurch gekennzeichnet, dass** das Übergitter (SL) mehrere Barriereschichten (BA) und mehrere Topfschichten (QW) umfasst, wobei die Barriereschichten (BA) und die Topfschichten (QW) alternierend gestapelt sind.

5. Stapelförmige Mehrfach-Solarzelle (MJ) nach einem der vorangegangenen Ansprüche, **dadurch gekennzeichnet, dass** jede Barriereschicht (BA) eine Schichtdicke (D1) von höchstens 6 nm aufweist und jede Topfschicht (QW) eine Schichtdicke (D2) von höchstens 8 nm aufweist.

6. Stapelförmige Mehrfach-Solarzelle (MJ) nach einem der vorangegangenen Ansprüche, **dadurch gekennzeichnet, dass** jede Barriereschicht (BA) eine erste Dotierstoffkonzentration aufweist, jede Topfschicht (QW) eine zweite Dotierstoffkonzentration aufweist und die erste Dotierstoffkonzentration gleich oder größer oder kleiner ist als die zweite Dotierstoffkonzentration.

7. Stapelförmige Mehrfach-Solarzelle (MJ) nach einem der vorangegangenen Ansprüche, **dadurch gekennzeichnet, dass** das Übergitter (SL) eine Gesamtdicke (D_{SL}) kleiner als 500 nm oder zwischen 20 nm und 100 nm aufweist.

8. Stapelförmige Mehrfach-Solarzelle (MJ) nach einem der vorangegangenen Ansprüche, **dadurch gekennzeichnet, dass** das Übergitter (SL) zwischen 3 und 100 alternierende Schichtpaaren aus Topfschichten und Barriereschichten umfasst.

9. Stapelförmige Mehrfach-Solarzelle (MJ) nach einem der vorangegangenen Ansprüche, **dadurch gekennzeichnet, dass** das Übergitter (SL) einen Schichtwiderstand kleiner als 1200 Ω/□ oder kleiner als 700 Ω/□ aufweist.

10. Stapelförmige Mehrfach-Solarzelle (MJ) nach einem der vorangegangenen Ansprüche, **dadurch gekennzeichnet, dass** der Emitter (E3) der obersten Teilzelle (C3) Al umfasst.

11. Stapelförmige Mehrfach-Solarzelle (MJ) nach einem der vorangegangenen Ansprüche, **dadurch gekennzeichnet, dass** mindestens vier Teilzellen oder genau vier Teilzellen oder genau fünf Teilzellen vorgesehen sind und die oberste Teilzelle eine Bandlücke zwischen 1,75 eV und 2,1 eV aufweist und die zweitoberste Teilzelle eine Bandlücke zwischen 1,55 eV und 1,75 eV aufweist und der Emitter und die Basis der zweitobersten Teilzelle InGaP umfasst oder aus InGaP besteht.

## Claims

1. A stacked multi-junction solar cell (MJ) comprising a stack (ST) of a bottom subcell (C1), at least one middle subcell (C2) and a top subcell (C3), wherein
- each subcell (C1, C2, C3) has an emitter (E1, E2, E3) and a base (B1, B2, B3),
- at least the top subcell (C3) consists of a III-V semiconductor material or comprises a III-V semiconductor material, the light penetrating through the top subcell to the further subcells, wherein
- the base (B3) of the top subcell (C3) consists of p-AlInGaP or at least comprises AlInGaP,
**characterized in that**
- the emitter (E3) of the top subcell (C3) comprises a superlattice (SL) or consists of a superlattice (SL),
- the superlattice (SL) is formed only in the emitter of the top subcell (C3),
- the superlattice (SL) is formed as an n-InAlP / n-InGaP superlattice with n-InAlP as barrier layer and n-InGaP as quantum well layer), or
- the superlattice (SL) is formed as an n-InₓGa₁₋ₓP / n-In_{y}Ga_{1-y}P superlattice, the In content in the quantum well layer (x) being greater than the In content in the barrier layers (y).

2. The stacked multi-junction solar cell (MJ) according to claim 1, **characterized in that** the superlattice (SL) consists of a plurality of stacked layers, adjacent layers differing from one another with respect to a composition in at least one chemical element and/or with respect to the stoichiometry.

3. The stacked multi-junction solar cell (MJ) according to claim 1 or 2, **characterized in that** the emitter (E3) of the top subcell comprises, in addition to the superlattice (SL), a further layer, and the further layer is part of the emitter (E3).

4. The stacked multi-junction solar cell (MJ) according to claim 1 or 2 or 3, **characterized in that** the superlattice (SL) comprises a plurality of barrier layers (BA) and a plurality of quantum well layers (QW), the barrier layers (BA) and the quantum well layers (QW) being stacked alternately.

5. The stacked multi-junction solar cell (MJ) according to any one of the preceding claims, **characterized in that** each barrier layer (BA) has a layer thickness (D1) of at most 6 nm and each quantum well layer (QW) has a layer thickness (D2) of at most 8 nm.

6. The stacked multi-junction solar cell (MJ) according to any one of the preceding claims, **characterized in that** each barrier layer (BA) has a first dopant concentration, each quantum well layer (QW) has a second dopant concentration, and the first dopant concentration is equal to, greater than, or smaller than the second dopant concentration.

7. The stacked multi-junction solar cell (MJ) according to any one of the preceding claims, **characterized in that** the superlattice (SL) has a total thickness (D_{SL}) of less than 500 nm or between 20 nm and 100 nm.

8. The stacked multi-junction solar cell (MJ) according to any one of the preceding claims, **characterized in that** the superlattice (SL) comprises between 3 and 100 alternating layer pairs of quantum well layers and barrier layers.

9. The stacked multi-junction solar cell (MJ) according to any one of the preceding claims, **characterized in that** the superlattice (SL) has a sheet resistance of less than 1200 Ω/□ or less than 700 Ω/□.

10. The stacked multi-junction solar cell (MJ) according to any one of the preceding claims, **characterized in that** the emitter (E3) of the top subcell (C3) comprises Al.

11. The stacked multi-junction solar cell (MJ) according to any one of the preceding claims, **characterized in that** at least four subcells or exactly four subcells or exactly five subcells are provided, and the top subcell has a band gap between 1.75 eV and 2.1 eV, and the second-topmost subcell has a band gap between 1.55 eV and 1.75 eV, and the emitter and the base of the second-topmost subcell comprise InGaP or consist of InGaP.

## Revendications

1. Cellule solaire multijonction empilée (MJ) comprenant un empilement (ST) d'une sous-cellule inférieure (C1), d'au moins une sous-cellule intermédiaire (C2) et d'une sous-cellule supérieure (C3), dans laquelle
- chaque sous-cellule (C1, C2, C3) présente un émetteur (E1, E2, E3) et une base (B1, B2, B3),
- au moins la sous-cellule supérieure (C3) est constituée d'un matériau semi-conducteur III-V ou comprend un matériau semi-conducteur III-V, la lumière pénétrant à travers la sous-cellule supérieure jusqu'aux autres sous-cellules, dans laquelle
- la base (B3) de la sous-cellule supérieure (C3) est constituée de p-AlInGaP ou comprend au moins de l'AlInGaP,
**caractérisée en ce que**
- l'émetteur (E3) de la sous-cellule supérieure (C3) comprend un super-réseau (SL) ou est constitué d'un super-réseau (SL),
- le super-réseau (SL) est formé uniquement dans l'émetteur de la sous-cellule supérieure (C3),
- le super-réseau (SL) est formé en tant que super-réseau n-InAlP / n-InGaP avec n-InAlP comme couche barrière et n-InGaP comme couche de puits quantique , ou
- le super-réseau (SL) est formé en tant que super-réseau n-InₓGa₁₋ₓP / n-In_{y}Ga_{1-y}P, la teneur en In dans les couche de puits quantiques (x) étant supérieure à la teneur en In dans les couches barrières (y).

2. Cellule solaire multijonction empilée (MJ) selon la revendication 1, **caractérisée en ce que** le super-réseau (SL) est constitué de plusieurs couches empilées, des couches adjacentes se différenciant l'une de l'autre quant à une composition dans au moins un élément chimique et/ou quant à la stœchiométrie.

3. Cellule solaire multijonction empilée (MJ) selon la revendication 1 ou 2, **caractérisée en ce que** l'émetteur (E3) de la sous-cellule supérieure comprend, en plus du super-réseau (SL), une autre couche, et l'autre couche fait partie de l'émetteur (E3).

4. Cellule solaire multijonction empilée (MJ) selon la revendication 1, 2 ou 3, **caractérisée en ce que** le super-réseau (SL) comprend plusieurs couches barrières (BA) et plusieurs couche de puits quantiques (QW), les couches barrières (BA) et les couche de puits quantiques (QW) étant empilées de manière alternée.

5. Cellule solaire multijonction empilée (MJ) selon l'une quelconque des revendications précédentes, **caractérisée en ce que** chaque couche barrière (BA) présente une épaisseur de couche (D1) d'au plus 6 nm et chaque couche de puits quantique (QW) présente une épaisseur de couche (D2) d'au plus 8 nm.

6. Cellule solaire multijonction empilée (MJ) selon l'une quelconque des revendications précédentes, **caractérisée en ce que** chaque couche barrière (BA) présente une première concentration en dopant, chaque couche de puits quantique (QW) présente une deuxième concentration en dopant, et la première concentration en dopant est égale, supérieure ou inférieure à la deuxième concentration en dopant.

7. Cellule solaire multijonction empilée (MJ) selon l'une quelconque des revendications précédentes, **caractérisée en ce que** le super-réseau (SL) présente une épaisseur totale (D_{SL}) inférieure à 500 nm ou comprise entre 20 nm et 100 nm.

8. Cellule solaire multijonction empilée (MJ) selon l'une quelconque des revendications précédentes, **caractérisée en ce que** le super-réseau (SL) comprend entre 3 et 100 paires de couches alternées de couche de puits quantiques et de couches barrières.

9. Cellule solaire multijonction empilée (MJ) selon l'une quelconque des revendications précédentes, **caractérisée en ce que** le super-réseau (SL) présente une résistance de couche inférieure à 1200 Ω/□ ou inférieure à 700 Ω/□.

10. Cellule solaire multijonction empilée (MJ) selon l'une quelconque des revendications précédentes, **caractérisée en ce que** l'émetteur (E3) de la sous-cellule supérieure (C3) comprend de l'Al.

11. Cellule solaire multijonction empilée (MJ) selon l'une quelconque des revendications précédentes, **caractérisée en ce qu'**au moins quatre sous-cellules ou exactement quatre sous-cellules ou exactement cinq sous-cellules sont prévues, et la sous-cellule supérieure présente une bande interdite comprise entre 1,75 eV et 2,1 eV, et la deuxième sous-cellule à partir du haut présente une bande interdite comprise entre 1,55 eV et 1,75 eV, et l'émetteur et la base de la deuxième sous-cellule à partir du haut comprennent de l'InGaP ou sont constitués d'InGaP.
